# EUROPÄISCHE PATENTSCHRIFT

(11) **EP 1 186 898 B1**
(45) Veröffentlichungstag und Bekanntmachung des Hinweises auf die Patenterteilung: **28.12.2005**
(21) Anmeldenummer: 01119256.4
(22) Anmeldetag: 09.08.2001
(51) Int. Cl.: G01R 31/28, G01R 1/073, G01N 21/41, G01N 21/88, G01B 11/06, G06K 9/64

(54) **Verfahren und Vorrichtung zum Prüfen von Leiterplatten**
Procedure and apparatus for testing printed circuit boards
Procédé et appareil pour tester des circuits imprimés

(30) Priorität: 05.09.2000 DE 10043726
(43) Veröffentlichungstag der Anmeldung: 13.03.2002
(73) Patentinhaber: atg test systems GmbH & Co. KG, 97877 Wertheim (DE)
(72) Erfinder: Lutz, Günter, 97892 Kreuzwertheim (DE)
(74) Vertreter: Ganahl, Bernhard

(56) Entgegenhaltungen:
- EP-A- 0 468 153
- WO-A-93/15474
- DE-A- 2 012 446
- DE-A- 3 212 190
- US-A- 4 240 750
- US-A- 4 427 496
- US-A- 4 570 180
- US-A- 4 650 333
- US-A- 4 721 908
- US-A- 4 758 782
- US-A- 5 299 268
- US-A- 5 333 052

## Beschreibung

Die Erfindung betrifft ein Verfahren und eine Vorrichtung zum Prüfen von Leiterplatten, insbesondere zum Prüfen von unbestückten Leiterplatten.

Leiterplatten weisen eine Vielzahl Netze auf, deren Dichte sich mit der kontinuierlich fortsetzenden Miniaturisierung der elektronischen Bauelemente zunehmend erhöht. In entsprechender Weise erhöht sich auch die Dichte der Kontaktstellen der Leiterplatten, die im nachfolgenden als Leiterplattentestpunkte bezeichnet werden.

Bekannte Vorrichtungen zum elektrischen Prüfen von Leiterplatten können grundsätzlich in zwei Gruppen eingeteilt werden. Die erste Gruppe wird durch die Paralleltester dargestellt, die einen Adapter aufweisen, mit welchem alle abzutastenden Leiterplattentestpunkte einer Leiterplatte gleichzeitig kontaktiert werden. Die zweite Gruppe umfasst die sequentiellen Tester. Hierunter fallen insbesondere die Fingertester. Das sind Vorrichtungen, die mit zwei oder mehreren Kontaktfingern die einzelnen Leiterplattentestpunkte sequentiell abtasten.

Paralleltester bzw. Adapter für Paralleltester gehen beispielsweise aus der DE 38 14 620 A, der DE 38 18 686 A, der DE 42 37 591 A1, der DE 44 06 538 A1, der DE 38 38 413 A1, der DE 43 23 276 A, der EP 215 146 B1 und der EP 144 682 B1 hervor. Derartige Adapter bestehen in der Regel aus mehreren Führungsplatten, in welchen Bohrungen eingebracht sind. Durch die Bohrungen erstrecken sich Prüfnadeln. Diese Prüfnadeln können jedoch nicht beliebig eng aneinander angeordnet werden. Es ist deshalb in der Regel nicht möglich, mit einem solchen Adapter Leiterplattentestpunkte zu kontaktieren, deren Abstand nicht größer als 300 µm ist.

Fingertester sind beispielsweise aus der DE 41 09 684 A1 bzw. der EP 0 468 153 A1 bekannt. Fingertester weisen eine hohe Flexibilität auf, da beim Wechsel des zu testenden Leiterplattentyps keine mechanischen Änderungen vorgenommen werden müssen. Fingertester tasten mit ihren Testfingem sequentiell die einzelnen Leiterplattentestpunkte ab. Die Kontaktfinger können mit einer Genauigkeit von z.B. 5 µm positioniert werden. Je nach Design der Kontaktfinger können jedoch zwei Kontaktfinger nicht beliebig eng nebeneinander angeordnet werden, so dass zwei nebeneinander liegenden Leiterplattentestpunkte mit einem Mittenabstand von weniger als 100 µm bis 300 µm nicht gleichzeitig kontaktierbar sind.

Zum Testen von Leiterplatten sind weiterhin Prüfvorrichtungen bekannt, die die Leiterplattentestpunkte mittels eines Plasmas elektrisch kontaktieren. Das Plasma wird z.B. mittels eines Laserstrahls erzeugt. Eine weitere Möglichkeit zum berührungslosen Kontaktieren liegt in der Verwendung eines Elektronenstrahls. Bei diesem berührungslos arbeitenden Prüfvorrichtungen ist es problematisch sehr eng beieinander liegenden Testpunkte zu kontaktieren. Erzeugt man nämlich zwei eng beieinander liegende Plasmabereiche so besteht eine erhebliche Gefahr, dass der Zwischenbereich entsprechend erhitzt und ionisiert wird, wodurch sich die beiden Plasmabereiche vereinigen würden. Dies stellt einen Kurzschluss dar, der ein sinnvolle Messung unmöglich macht.

Bei all den oben beschriebenen elektrischen Testverfahren zum Prüfen einer Leiterplatte ist es problematisch oder zumindest sehr aufwendig, eng beieinander liegende Leiterplattentestpunkte mit z.B. einem Mittenabstand von 100 µm bis 300 µm zu testen.

Das Testen von Leiterplatten mittels optischer Testverfahren und Testvorrichtungen ist bekannt (z.B. WO 92/09880, WO 93/15474). Derartige Vorrichtungen weisen eine optische Abtasteinrichtung auf, wie z.B. eine Kamera, mit welcher eine zu testende Leiterplatte abgetastet wird. Die so ermittelte Abbildung der Leiterplatte wird digitalisiert, d.h., dass eine Bilddaten-Datei erstellt wird, deren Dateninhalt der Abbildung entspricht.

Die Bilddaten-Datei besteht in der Regel aus einer Liste von Koordinaten, wobei jeder Koordinate ein Grauwert zugeordnet ist. Diese Bilddaten-Datei wird automatisch mittels eines Erkennungsprogramms gelesen, das die einzelnen Leiterbahnen, Kontaktstellen und dgl. erkennt und in einer Merkmalsdatei abspeichert, in der alle optischen Merkmale der zu testenden Leiterplatte enthalten sind.

Diese Merkmalsdatei wird mit einer Referenz-Merkmalsdatei verglichen. Werden bei diesem Vergleich keine Abweichungen festgestellt, so ist die getestete Leiterplatte fehlerfrei. Sollten aber Abweichungen festgestellt werden, so ist dies ein Hinweis, dass die zu testende Leiterplatte einen Fehler, wie z.B. einen Kurzschluss oder eine Unterbrechung in einem Netz, aufweist.

Diese Fehler müssen dann vom Bediener der Prüfvorrichtung manuell untersucht werden. Der Bediener, der in der Regel viel Erfahrung im Testen von Leiterplatten besitzen sollte, betrachtet die Leiterplatte mit dem bloßen Auge und beurteilt, ob die optischen Abweichungen tatsächlich Fehler darstellen, oder ob sie auf irgendwelchen anderen Ursachen beruhen, wie z.B. Flecken oder dgl.

Diese optischen Prüfvorrichtungen erlauben einen sehr schnellen Test einer Lage einer Leiterplatte vor dem Zusammenfügen der einzelnen Lagen zu einer Leiterplatte. Mit derartigen Prüfvorrichtungen können unterschiedliche Leiterplatten getestet werden, ohne dass hierfür mechanische Änderungen an der Vorrichtung notwendig sind. An fertigen Leiterplatten werden Außenlagen mit der optischen Prüfvorrichtung getestet.

Nachteilig ist jedoch, dass bei fehlerhaften Leiterplatten in der Regel eine manuelle Untersuchung erfolgen muss. Dies bedeutet eine wesentliche Verzögerung des an sich sehr schnellen Testverfahrens. Zudem sind die optischen Testverfahren sehr personalintensiv, und die manuellen Untersuchungen können nur Bediener mit viel Erfahrung beim Testen von Leiterplatten durchführen.

Aus der US 4,240,750 geht ein Verfahren zum optischen Testen von Leiterplatten hervor. Bei diesem Verfahren wird ein Laserstrahl auf die zu testende Leiterplatte gerichtet. Das von der Leiterplatte reflektierte Licht oder gestreutes Licht wird erfasst. Anhand der Intensität des erfassten Lichtes kann festgestellt werden, ob auf der Leiterplatte ein Fehler vorliegt.

Der Erfindung liegt die Aufgabe zugrunde, ein Verfahren und eine Vorrichtung zu schaffen, mit welchem einfach und zuverlässig Leiterplatten mit hoher Kontaktpunktdichte getestet werden können.

Die Aufgabe wird durch ein Verfahren mit den Merkmalen des Anspruchs 1 und durch eine Vorrichtung mit den Merkmalen des Anspruchs 6 gelöst. Vorteilhafte Ausgestaltungen sind in den Unteransprüchen angegeben.

Nach dem erfindungsgemäßen Verfahren zum Prüfen von Leiterplatten, die Leiterbahnen aufweisen, deren Endpunkte als Leiterplattentestpunkte ausgebildet sind, werden folgende Schritte ausgeführt:
- Bestimmen von Abtastbereichen, in denen jeweils eine Gruppe von eng nebeneinander liegenden Leiterplattentestpunkten angeordnet ist,
- optisches Prüfen auf Kurzschluss und Unterbrechung der Gruppen von Leiterplattentestpunkten und ggfs. von damit verbundenen Leiterbahnen innerhalb der Abtastbereiche, wobei die Gruppen von Leiterplattentestpunkte und Leiterbahnen jeweils vollständig innerhalb der Abtastbereiche angeordnet sind, und
- elektrisches Prüfen auf Kurzschluss und Unterbrechungen der übrigen Leiterplattentestpunkte und der übrigen Leiterbahnen.

Wie es eingangs erläutert worden ist, ist das elektrische Testen von eng beieinanderliegenden Leiterplattentestpunkten oftmals schwierig, da diese Leiterplattentestpunkte beim Testen bzw. Prüfen gleichzeitig korrekt kontaktiert sein müssen. Bei sehr kleinen Abständen von weniger als 300 µm oder weniger als 100 µm ist es bei manchen elektrischen Testverfahren nicht möglich derartige Leiterplattentestpunkte sicher zu kontaktieren.

Die Bereiche, in welchen elektrisch nur sehr aufwendig abzutastende Leiterplattentestpunkte angeordnet sind, werden erfindungsgemäß optisch gemessen. Diese Bereiche werden nachfolgend als Abtastbereiche bezeichnet. Hierbei ist von Vorteil, dass die Leiterbahnen, die benachbart und damit eng nebeneinander angeordnete Leiterplattentestpunkte verbinden, auf der Oberfläche der zu testenden Leiterplatte ausgebildet sind. Diese Leiterbahnen können optisch gut erfasst werden. Diese eng beieinander liegenden Leiterplattentestpunkte können mit hoher Zuverlässigkeit vollautomatisch optisch getestet werden, da die optisch auszuwertenden Bereiche jeweils kleine Ausschnitte der zu testenden Leiterplatten sind, die sicher und einfach automatisch ausgewertet werden können.

Das erfindungsgemäße Verfahren erlaubt somit auf einfache Art und Weise einen zuverlässigen Test aller Leiterplattentestpunkte einer zu testenden Leiterplatte. Insbesondere können mit der Erfindung komplexe Leiterplatten mit mehreren Lagen und mit Bereichen, in welchen Leiterplattentestpunkte in Hoher Dichte angeordnet sind, sicher und einfach getestet werden.

Das elektrische Testen kann mittels eines Paralleltesters, Fingertesters, Plasma-, Laser- oder Elektronenstrahltesters erfolgen.

Die Erfindung wird nachfolgend näher anhand der in den beiliegenden Zeichnungen dargestellten Ausführungsbeispiele erläutert. In den Zeichnungen zeigen schematisch:
- Fig. 1: eine Vorrichtung zum Ausführen des erfindungsgemäßen Verfahrens nach einem ersten Ausführungsbeispiel in perspektivischer Ansicht,
- Fig. 2: eine Vorrichtung zum Ausführen des erfindungsgemäßen Verfahrens nach einem zweiten Ausführungsbeispiel in perspektivischer Ansicht,
- Fig. 3: eine Vorrichtung zum Ausführen des erfindungsgemäßen Verfahrens nach einem dritten Ausführungsbeispiel in perspektivischer Ansicht, und
- Fig. 4: einen Bereich einer zu testenden Leiterplatte in der Draufsicht.

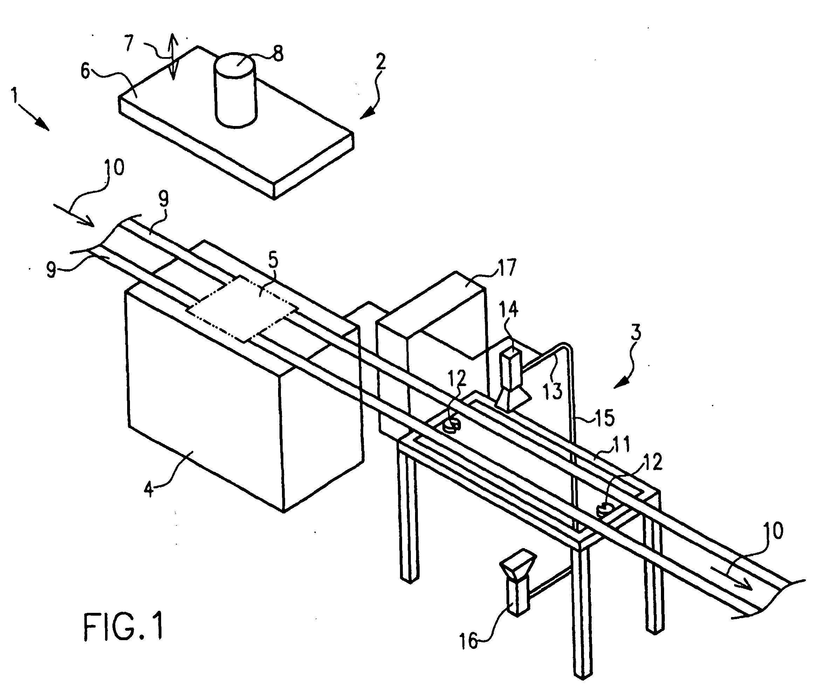

Fig. 1 zeigt schematisch eine erfindungsgemäße Prüfvorrichtung 1 mit einem Paralleltester 2 und einer optischen Messstation 3.

Der Paralleltester 2 weist einen Grundkörper 4 auf, an dessen Oberseite ein Aufnahmebereich 5 zum Aufnehmen einer zu testenden Leiterplatte ausgebildet ist. Der Aufnahmebereich ist mit einem Adapter versehen, der Prüfnadeln als Kontaktelemente aufweist, die gleichzeitig mehrere Leiterplattentestpunkte der zu testenden Leiterplatte kontaktieren können. Oberhalb des Grundkörpers 4 ist eine Andruckplatte 6 angeordnet. Die Andruckplatte 6 ist mittels eines Druckmechanismus vertikal verstellbar (Doppelpfeil 7). Der Andruckmechanismus ist schematisch durch einen Andruckzylinder 8 dargestellt. An der Unterseite der Andruckplatte 6 ist gegenüberliegend zum Aufnahmebereich 5 ein weiterer Adapter mit als Kontaktelemente dienenden Prüfnadeln angeordnet. Die Andruckplatte 6 kann bis zur Oberseite des Grundkörpers 4 abgesenkt werden, so dass eine zu testende Leiterplatte an beiden Seiten mit den beiden Adaptern elektrisch kontaktiert wird. Zwischen dem Grundkörper 4 und der Andruckplatte 6 sind zwei Förderbänder angeordnet, die in Förderrichtung 10 zu testende Leiterplatten befördern. Die Fördereinrichtung führt von einer an sich bekannten Vereinzelungsstation (nicht dargestellt) in Förderrichtung 10 zum Paralleltester 2, zur optischen Messstation 3 und zu einer an sich bekannten Sammelstation (nicht dargestellt) zum Sammeln der getesteten Leiterplatten.

Die optische Messstation 3 weist einen Rahmen 11 auf, an dem Greifelemente 12 zum Halten einer zu testenden Leiterplatte angeordnet sind. Über dem Rahmen 11 ist mittels Haltestreben 13 eine obere Kamera 14 befestigt, die mit ihrem Objektiv auf den vom Rahmen 11 aufgespannten Bereich ausgerichtet ist, so dass eine im Rahmen 11 gehaltene Leiterplatte vollständig von der Kamera 14 abgetastet werden kann. Unterhalb des Rahmens ist mit weiteren Haltestreben 15 eine untere Kamera 16 angeordnet, die mit ihrem Objektiv nach oben auf den vom Rahmen aufgespannten Bereich gerichtet ist, so dass eine im Rahmen gehaltene Leiterplatte vollständig von der unteren Kamera 16 abgetastet werden kann.

Sowohl der Paralleltester 2 als auch die optische Messstation 3 sind mit einer Steuereinrichtung 17 verbunden, die den Paralleltester 2 als auch die optische Messstation 3 sowie die Fördereinrichtung ansteuern.

Nachfolgend wird das Verfahren zum Prüfen von Leiterplatten mit der in Fig. 1 gezeigten Vorrichtung näher erläutert.

Eine zu testende Leiterplatte wird zunächst mittels der Fördereinrichtung in den Aufnahmebereich 5 des Paralleltesters 2 befördert. Zum Testen dieser Leiterplatte wird die Andruckplatte 6 abgesenkt, so dass Leiterplattentestpunkte auf beiden Seiten der zu testenden Leiterplatte von den beiden Adaptern elektrisch kontaktiert werden. Hierauf wird die Leiterplatte in an sich bekannter Weise auf Unterbrechungen und Kurzschlüsse getestet. Nach dem Testen wird die Andruckplatte 6 angehoben und die Leiterplatte wieder freigegeben.

Die Leiterplatte wird zur optischen Messstation befördert und mittels der Greifelemente 12 im Rahmen 11 fixiert. Die Oberseite der zu testenden Leiterplatte wird mittels der oberen Kamera 14 abgetastet und die Unterseite wird mittels der unteren Kamera 16 abgetastet. Die hierdurch erzeugten digitalen Bilder werden ausgewertet, wobei lediglich Abtastbereiche auf der Leiterplatte ausgewertet werden. In den Abtastbereichen sind zumindest zwei Leiterplattentestpunkte eng beieinanderliegend angeordnet und falls diese Leiterplattentestpunkte mittels Leiterbahnen mit weiteren Leiterplattentestpunkten verbunden sind, sind diese weiteren Leiterplattentestpunkte innerhalb des jeweiligen Abtastbereichs angeordnet. Diese Abtastbereiche werden einmal vorab bestimmt und für die Auswertung der digitalen Bilder festgelegt. Sie umfassen in der Regel nur einen geringen Bruchteil der gesamten Fläche einer zu prüfenden Leiterplatte. Dieser Bruchteil kann z.B. im Bereich von 3% bis 10 % liegen.

Diese Leiterplattentestpunkte bzw. die damit verbundenen Leiterbahnen werden auf Unterbrechungen und Kurzschlüsse untersucht.

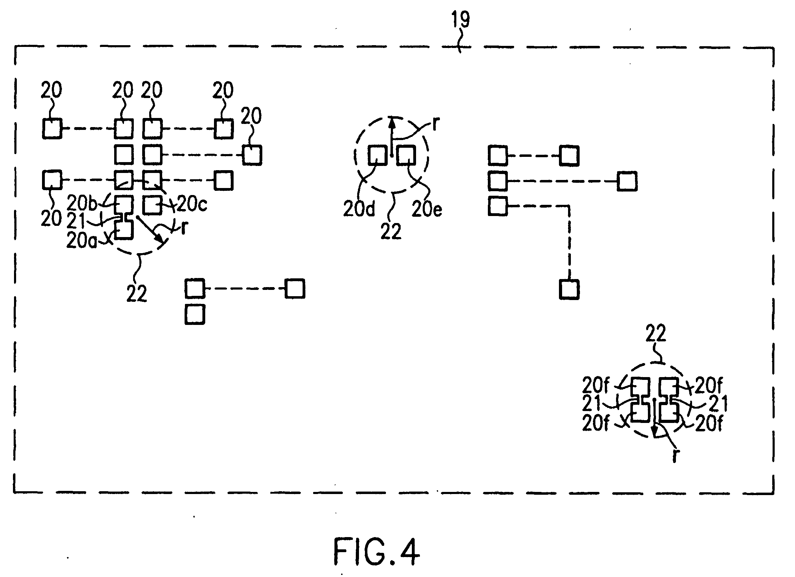

Fig. 4 zeigt schematisch einen Bereich einer zu testenden Leiterplatte 19 in einer Draufsicht mit einigen wenigen Leiterplattentestpunkten 20. Eine erste Gruppe von Leiterplattentestpunkten 20a, 20b und 20c sind benachbart zueinander angeordnet, wobei die Leiterplattentestpunkte 20a, 20b mit einer Leiterbahn 21 elektrisch miteinander verbunden sind. Da diese Leiterbahn 21 zwei benachbart angeordnete Leiterplattentestpunkte 20a, 20b verbindet ist sie auf der Oberfläche der Leiterplatte ausgebildet und kann somit optisch einfach erfasst werden. Neben dem Leiterplattentestpunkt 20b befindet sich der Leiterplattentestpunkt 20c. Dieser Leiterplattentestpunkt 20c ist mit keiner Leiterbahn verbunden. An derartigen einzelne Leiterplattentestpunkten werden Anschlüsse von elektrischen Bauteilen lediglich zur mechanischen Befestigung an die Leiterplatte angelötet. Jedoch muss auch sichergestellt sein, dass diese einzelnen Leiterplattentestpunkte nicht mit einem anderen Leiterplattentestpunkt oder einer Leiterbahn elektrisch verbunden sind.

Die Leiterplattentestpunkte 20a, 20b und 20c liegen innerhalb eines Abtastbereiches 22 mit vorbestimmten Radius r. Der Radius r des Abtastbereichs 22 beträgt bspw. 100 bis 200 µm. Es kann jedoch auch zweckmäßig sein, den Radius r auf 50 µm festzulegen.

Die weiteren Leiterplattentestpunkte 20, die in Fig.4 im Bereich oberhalb des Abtastbereiches 22 angeordnet sind, sind über Leiterbahnen 21 mit weiteren Leiterplattentestpunkten 20 verbunden. Da diese Leiterbahnen 21 in der Regel nicht auf der Oberfläche der Leiterplatte sondern in einer Zwischenschicht zwischen zwei Lagen der Leiterplatte ausgebildet sind, sind sie in Fig. 4 durch eine Strichlinie dargestellt. Die Länge dieser Leiterbahnen 21 ist größer als der Durchmesser 2r des Abtastbereiches 22, so dass jeweils eine aus zwei Leiterplattentestpunkten 20 und einer Leiterbahn 21 bestehende Struktur elektrisch einfach gegenüber einem anderen Leiterplattentestpunkt bzw. einer anderen Leiterbahn getestet werden kann.

Diese Leiterplatte weist eine zweite Gruppe einzelner benachbart angeordneter Leiterplattentestpunkte 20d, 20e auf, die innerhalb eines weiteren Abtastbereiches 22 liegen. Da diese beiden Leiterplattentestpunkte 20d, 20e sehr eng nebeneinander angeordnet sind, können sie nicht ohne erheblichen Aufwand elektrisch gleichzeitig und sicher kontaktiert werden. Der Abtastbereich 22 wird deshalb optisch dahingehend ausgewertet, ob ein Kurzschluss zwischen den beiden Leiterplattentestpunkten 20d, 20e vorliegt.

Weiterhin weist diese Leiterplatte eine dritte Gruppe von vier Leiterplattentestpunkten 20f auf, die zueinander eng benachbart angeordnet sind. Diese vier Leiterplattentestpunkte sind paarweise mittels Leiterbahnen 21 elektrisch miteinander verbunden. Da diese Einheiten aus Leiterbahnen 21 und Leiterplattentestpunkten 20f innerhalb eines Abtastbereiches 22 liegen, sind sie elektrisch nicht ohne erheblichen Aufwand gleichzeitig sicher kontaktierbar, weshalb sie mittels einer optischen Auswertung auf Kurzschlüsse und Unterbrechungen getestet werden.

Mit dem erfindungsgemäßen Verfahren werden somit alle aus Leiterplattentestpunkten und eventuell Leiterbahnen bestehende Paare von Strukturen, die jeweils vollständig innerhalb eines Abtastbereiches mit vorbestimmten Radius r angeordnet sind, durch Auswerten des optisch erfassten Bildes auf Kurzschluss und Unterbrechung getestet. Diese Strukturen werden gegenüber den anderen Strukturen elektrisch auf Kurzschluss getestet und alle übrigen Strukturen werden elektrisch auf Kurzschluss und Unterbrechungen getestet.

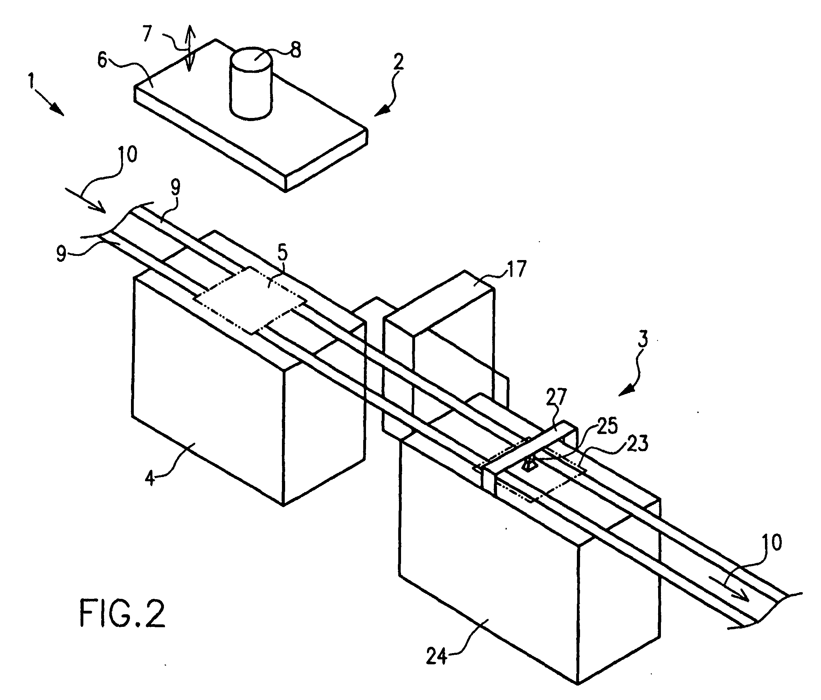

Fig. 2 zeigt ein zweites Ausführungsbeispiel der erfindungsgemäßen Prüfvorrichtung. Dieses Ausführungsbeispiel weist wiederum einen Paralleltester 2 und eine optische Messstation 3 auf. Der Paralleltester 2 und die Fördereinrichtung sind identisch zum ersten Ausführungsbeispiel ausgebildet, weshalb die entsprechenden gleichen Teile mit gleichen Bezugszeichen bezeichnet sind.

Die optische Messstation 3 weist einen Grundkörper 24 auf, dessen Oberseite einen Aufnahmebereich 23 zum Aufnehmen einer zu testenden Leiterplatte ausgebildet ist. Der Aufnahmebereich 23 wird von einer Traverse 27 überspannt, die auf dem Grundkörper 24 in und entgegen zur Förderrichtung 10 verfahrbar ist. An der Traverse 27 ist eine Kamera 25 angeordnet, die an der Traverse 27 quer zur Transportrichtung 10 verfahrbar ist, so dass durch die Verfahrbarkeit der Traverse 27 auf dem Grundkörper 24 und der Verfahrbarkeit der Kamera 25 an der Traverse 27 die Kamera 25 über jeder beliebigen Position des Aufnahmebereiches 23 angeordnet werden kann. Die Kamera 25 ist mit ihrem Objektiv nach unten in Richtung zum Aufnahmebereich 23 gerichtet.

Die Funktionsweise der in Fig. 2 gezeigten Vorrichtung entspricht der in Fig. 1 gezeigten Vorrichtung, wobei beim optischen Testen die Kamera 25 jeweils über die Bereiche der Leiterplatte positioniert wird, an welchen sich benachbarte elektrisch über eine Leiterbahn verbundene Leiterplattentestpunkte befinden. Da die Kamera 25 sehr nahe an der zu testenden Leiterplatte angeordnet ist, können diese Bereiche sehr genau erfasst und entsprechend präzise ausgewertet werden. Die in Fig. 2 gezeigte Vorrichtung erlaubt nur das optische Abtasten einer Seite einer zu testenden Leiterplatte. Dies ist oftmals zweckmäßig, da viele Leiterplatten auf einer Seite Leiterplattentestpunkte in sehr hoher Dichte aufweisen und auf der anderen Seite relativ wenige Leiterplattentestpunkte besitzen, die zueinander jeweils einen großen Abstand besitzen. Bei derartigen Leiterplatten muss jeweils nur die Seite mit der in dichter Anordnung ausgebildeten Leiterplattentestpunkte optisch getestet werden.

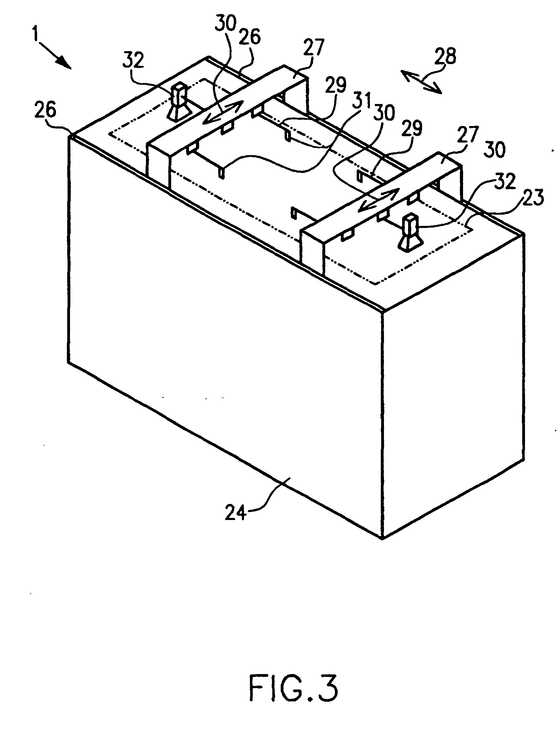

Fig. 3 zeigt ein weiteres Ausführungsbeispiel einer erfindungsgemäßen Prüfvorrichtung 1, die als Fingertester ausgebildet ist. Diese Prüfvorrichtung 1 weist einen Grundkörper 24 auf, an dessen Oberseite ein Aufnahmebereich 23 zum Aufnehmen einer zu testenden Leiterplatte ausgebildet ist. Die Oberseite des Grundkörpers 24 ist an den Längsseiten durch jeweils eine Schiene 26 begrenzt. Auf den Schienen 26 lagern zwei Traversen 27 die entlang der Schiene 26 verfahrbar sind (in Richtung des Doppelpfeils 28). An den Traversen 27 sind Kontaktfinger 29 angeordnet, die entlang der Traversen 27 verfahrbar sind. Die Kontaktfinger 29 weisen an ihren freien Enden Kontaktspitzen 31 auf, mit welchen die Leiterplattentestpunkte einer zu testenden Leiterplatte kontaktiert werden können. Durch die Verfahrbarkeit der Traversen 27 und der Kontaktfinger 29 wird sichergestellt, dass an jeder beliebigen Stelle des Aufnahmebereiches 23 eine Kontaktspitze 31 zum Kontaktieren eines Leiterplattentestpunktes positioniert werden kann. An den Traversen 27 sind zusätzlich jeweils eine Kamera 32 angeordnet. Die Kameras 32 sind wiederum entlang der Traversen 27 (in Richtung des Doppelpfeils 30) verfahrbar, so dass über jeder beliebigen Position des Aufnahmebereiches 23 eine Kamera 32 positioniert werden kann.

Die Kameras 32 sind mit ihren Objektiven jeweils nach unten in Richtung zum Aufnahmebereich 23 gerichtet.

Nachfolgend wird die Arbeitsweise der in Fig. 3 gezeigten Prüfvorrichtung 1 näher erläutert.

Mit den Kameras 32 werden Abtastbereiche der zu testenden Leiterplatte optisch abgetastet. Die von den Kameras 32 erzeugten digitalen Bilder werden dahingehend ausgewertet, ob eine Unterbrechung oder ein Kurzschluss an den Leiterbahnen zwischen den benachbarten Leiterplattentestpunkten vorliegen. Leiterplattentestpunkte, die über einen größeren Abstand elektrisch miteinander verbunden sind, werden mittels der Kontaktfinger 29 abgetastet und elektrisch gemessen.

Die optischen Messungen mittels der Kamera 32 und die elektrischen Messungen mittels der Kontaktfinger 29 können in beliebiger Reihenfolge ausgeführt werden. Beim Prüfen mit dieser Prüfvorrichtung 1 werden die oben erläuterten Vorteile durch die Kombination der optischen und elektrischen Messverfahren erzielt.

Die Erfindung ist oben anhand mehrerer Ausführungsbeispiele näher erläutert worden. Sie ist jedoch nicht auf die konkrete Ausführungsform der einzelnen Ausführungsbeispiele beschränkt. Im Rahmen der Erfindung ist es z.B. möglich, die in Fig. 3 gezeigte Vorrichtung derart auszubilden, dass zwei Seiten einer Leiterplatte mittels Kontaktfinger und Kameras abgetastet werden können. Werden mehrere Traversen vorgesehen, auf welchen die Kontaktfinger und die Kameras schwenkbar angeordnet sind, können diese Traversen auch statisch ausgebildet sein. Im Rahmen der Erfindung ist es z.B. auch möglich, dass die optischen Messungen vor den elektrischen Messungen ausgeführt werden. Dies bedeutet, dass z.B. die in Fig. 1 und Fig. 2 gezeigten Ausführungsbeispiele mit einer Fördereinrichtung versehen sein können, die in die entgegengesetzte Richtung die Leiterplatten befördert. Das Wesen der Erfindung liegt darin, dass eine elektrische und eine optische Messung derart kombiniert werden, dass eng beieinander liegende Leiterplattentestpunkte optisch vermessen werden und weitere Paare von Leiterplattenpunkte, die elektrisch miteinander verbunden sind, mittels eines elektrischen Messverfahrens getestet werden. Derartige elektrische Messverfahren können Berührungskontakte (Paralleltester, Fingertester) aufweisen oder berührungslose Messungen (Plasma-, Laserstrahl- oder Elektronenstrahlverfahren) ausführen.

## Patentansprüche

1. Verfahren zum Prüfen von Leiterplatten, wobei die Leiterplatten Leiterbahnen aufweisen, deren Endpunkte als Leiterplattentestpunkte ausgebildet sind, umfassend die Schritte:
- optisches Prüfen auf Kurzschluss und Unterbrechung der Gruppen von Leiterplattentestpunkten und ggfs. von damit verbundenen Leiterbahnen innerhalb von Abtastbereichen, in denen jeweils eine Gruppe von eng nebeneinander liegenden Leiterplattentestpunkten angeordnet ist, und
- elektrisches Prüfen auf Kurzschluss und Unterbrechungen der übrigen Leiterplattentestpunkte und der übrigen Leiterbahnen.

2. Verfahren nach Anspruch 1,
**dadurch gekennzeichnet,**
**dass** die Gruppen von Leiterplattentestpunkte und Leiterbahnen jeweils vollständig innerhalb der Abtastbereiche angeordnet sind,

3. Verfahren nach Anspruch 1 oder 2,
**dadurch gekennzeichnet,**
**dass** der Abstand der eng beieinander liegenden Leiterplattentestpunkte weniger als 300 µm beträgt.

4. Verfahren nach einem der Ansprüche 1 bis 3,
**dadurch gekennzeichnet,**
**dass** die Abtastbereiche einen Radius (r) von 150 bis 200 µm aufweisen.

5. Verfahren nach Anspruch 4,
**dadurch gekennzeichnet,**
**dass** der Radius (r) der Abtastbereiche 50 µm beträgt.

6. Verfahren nach einem der Ansprüche 1 bis 5,
**dadurch gekennzeichnet,**
**dass** zum elektrischen Prüfen ein Fingertester oder Paralleltester verwendet wird.

7. Verfahren nach einem der Ansprüche 1 bis 5,
**dadurch gekennzeichnet,**
**dass** das elektrische Prüfen berührungslos mittels eines Plasma-, Laserstrahl- oder Elektronenstrahlverfahren erfolgt.

8. Vorrichtung angepaßt zum Ausführen der Schritte eines Verfahrens nach einem der Ansprüche 1 bis 7, mit
- einer Einrichtung zum elektrischen Prüfen einer Leiterplatte, und
- einer Einrichtung zum optischen Prüfen von Gruppen von Leiterplattentestpunkten und ggfs. von damit verbundenen Leiterbahnen innerhalb von Abtastbereichen, wobei die Gruppen von Leiterplattentestpunkte und Leiterbahnen jeweils vollständig innerhalb der Abtastbereiche angeordnet sind.

9. Vorrichtung nach Anspruch 8,
**dadurch gekennzeichnet,**
**dass** die Einrichtung zum elektrischen Prüfen einer Leiterplatte ein Paralleltester (2) oder ein Fingertester ist und diese Einrichtung über eine Fördereinrichtung (9) zum Befördern von Leiterplatten mit einer einen optischen Sensor aufweisenden optischen Meßstation (3) verbunden ist.

10. Vorrichtung nach Anspruch 8,
**dadurch gekennzeichnet,**
**dass** die Einrichtung zum elektrischen Prüfen einer Leiterplatte ein Fingertester ist, die Kontaktfinger (29) und zumindest einen optischen Sensor (32) zum optischen Abtasten aufweist.

11. Vorrichtung nach Anspruch 9 oder 10,
**dadurch gekennzeichnet,**
**dass** der optische Sensor eine Kamera (32) ist.

## Claims

1. Method of testing circuit boards, wherein the circuit boards have conductor paths, the end points of which form circuit board test points, comprising the steps:
- optical testing for short and open circuits in the group of circuit board test points and where applicable in associated conductor paths within scanning zones in which in each case one group of circuit board test points being closely situated to each other and conductor paths is located, and
- electrical testing for short and open circuits in the remaining circuit board test points and the remaining conductor paths.

2. Method according to claim 1,
**characterized in that**
the group of circuit board test points and conductor paths is in each case located entirely within the scanning zones.

3. Method according to claim 1 or 2,
**characterized in that**
the distance between closely adjacent circuit board test points is less than 300 µm.

4. Method according to any of claims 1 to 3,
**characterized in that**
the scanning zones have a radius (r) of 150 to 200 µm.

5. Method according to claim 4,
**characterized in that**
the radius (r) of the scanning zones is 50 µm.

6. Method according to any of claims 1 to 5,
**characterized in that**
a finger tester or parallel tester is used for the electrical testing.

7. Method according to any of claims 1 to 5,
**characterized in that**
electrical testing is effected without contact by means of plasma, laser beam or electron beam methods.

8. Apparatus for the implementation of the steps of a method according to any of claims 1 to 7, with
- a device for electrical testing of a circuit board, and
- a device for optical testing of groups of circuit board test points and where applicable of associated conductor paths within scanning zones, wherein each of the groups of circuit board test points and conductor paths is located entirely within the scanning zones.

9. Apparatus according to claim 8,
**characterized in that**
the device for electrical testing of a circuit board is a parallel tester (2) or a finger tester and that this device is connected to a measuring station (3) having an optical sensor via a conveyor (9) for the transfer of circuit boards.

10. Apparatus according to claim 8,
**characterized in that**
the device for electrical testing of a circuit board is a finger tester, with contact fingers (29) and one or more optical sensors (32) for optical scanning.

11. Apparatus according to claim 9 or 10,
**characterized in that**
the optical sensor is a camera (32).

## Revendications

1. Procédé pour tester des cartes à circuits imprimés, dans lequel les cartes à circuits imprimés présentent des pistes conductrices dont les points terminaux sont réalisés sous forme de points de test pour les cartes, comprenant les étapes suivantes :
-- vérification optique de courts-circuits et de ruptures des groupes de points de test des cartes et le cas échéant des pistes conductrices reliées à ces points, à l'intérieur de zones de palpage dans lesquelles sont agencés des groupes respectifs de points de test de cartes disposés étroitement les uns à côté des autres, et
-- vérification électrique de courts-circuits et de rupture des autres points de test de cartes et des autres pistes conductrices.

2. Procédé selon la revendication 1, **caractérisé en ce que** les groupes de points de test de cartes et de pistes conductrices sont agencés respectivement totalement à l'intérieur des plages de palpage.

3. Procédé selon l'une ou l'autre des revendications 1 et 2, **caractérisé en ce que** la distance des points de test de cartes situés étroitement les uns à côté des autres est inférieure à 300 µ.

4. Procédé selon l'une des revendications 1 à 3, **caractérisé en ce que** les plages de palpage ont un rayon (r) de 150 à 200 µ.

5. Procédé selon la revendication 4, **caractérisé en ce que** le rayon (r) des plages de palpage s'élève à 50 µ.

6. Procédé selon l'une des revendications 1 à 5, **caractérisé en ce que** pour le contrôle électrique on utilise un testeur à pointe ou un testeur parallèle.

7. Procédé selon l'une des revendications 1 à 5, **caractérisé en ce que** le contrôle électrique a lieu sans contact au moyen d'un procédé à plasma, à faisceau laser ou à faisceau d'électrons.

8. Appareil conçu pour mettre en oeuvre les étapes d'un procédé selon l'une des revendications 1 à 7, comprenant :
-- des moyens pour le contrôle électrique d'une plaque à circuits imprimés, et
-- des moyens pour le contrôle optique de groupes de points de test de cartes et le cas échéant de pistes conductrices reliées à ces points, à l'intérieur de zones de palpage, tels que les groupes de points de test de cartes et les pistes conductrices sont agencé(e)s respectivement totalement à l'intérieur des plages de palpage.

9. Appareil selon la revendication 8, **caractérisé en ce que** les moyens pour le contrôle électrique d'une carte à circuits imprimés sont formés par un testeur parallèle (2) ou par un testeur à pointes, et **en ce que** ces moyens sont reliés à une station de mesure (3) optique comprenant un capteur optique, au-dessus d'un moyen de convoyage (9) pour le transport de plaques à circuits imprimés.

10. Appareil selon la revendication 8, **caractérisé en ce que** les moyens pour le contrôle électrique d'une plaque à circuits imprimés sont formés par un testeur à pointes, qui comprend des pointes de contact (29) et au moins un capteur optique (32) pour le palpage optique.

11. Appareil selon l'une ou l'autre des revendications 9 et 10, **caractérisé en ce que** le capteur optique est une caméra (32).
